# EUROPEAN PATENT APPLICATION

(11) **EP 4 800 922 A1**
(43) Date of publication of application: **02.09.2026**
(21) Application number: 24892676.8
(22) Date of filing: 26.04.2024
(51) Int. Cl.: H03F 1/02, H02M 3/156

(54) **BOOST POWER SUPPLY METHOD AND CIRCUIT, AND AUDIO DEVICE**

(30) Priority: 22.11.2023 CN 202311569731
(71) Applicant: Shanghai Awinic Technology Co., Ltd, Shanghai 201199 (CN)
(72) Inventor: YING, Hao, Shanghai 201199 (CN)
(74) Representative: Kraus & Lederer PartGmbB
(86) International application number: PCT/CN2024/090127
(87) International publication number: WO 2025/107510

(57) **Abstract**

Embodiments of the present disclosure provide a method for boost power supply, a boost power supply circuit and an audio device, wherein the method comprises: obtaining a boost threshold that changes synchronously with a power supply voltage; obtaining a signal value of an audio signal in an audio power amplifier, and comparing the signal value with the boost threshold to obtain a check flag signal; generating a corresponding boost control signal based on the check flag signal; obtaining a boosted power supply voltage based on the boost control signal, and powering a power output stage circuit of the audio power amplifier using the boosted power supply voltage. The embodiments of the present disclosure not only ensure the output power of the audio power amplifier, but also reduce the power loss thereof, thereby improving the efficiency of the audio power amplifier.

## Description

The present disclosure claims priority to an invention application with an application number of "202311569731.3" and a patent title of "METHOD FOR BOOST POWER SUPPLY, BOOST POWER SUPPLY CIRCUITAND AUDIO DEVICE" filed on 22 November 2023, the entire content of which is incorporated herein by reference.

### TECHNICAL FIELD

Embodiments of the present disclosure relate to the audio technical field, and in particular to, a method for boost power supply, a boost power supply circuit and an audio device.

### BACKGROUND

Efficiency of an audio power amplifier is closely associated with a magnitude of a power supply voltage powering the audio power amplifier. When a magnitude of an input signal from the audio power amplifier is determined, a large enough power supply voltage is required to provide sufficient driving capability to prevent an audio signal outputted from the audio power amplifier from being truncated. However, after the power supply voltage is large enough, continued boosting of the power supply voltage may increase the power loss of the audio power amplifier.

An output power of the audio power amplifier is an important indicator thereof. In order to ensure that the audio power amplifier can output a large enough power, a large power supply voltage needs to be provided to satisfy the requirements for outputting a large enough power from the audio power amplifier. However, when a small input signal is inputted into the audio power amplifier, a large power supply voltage is selected, thereby resulting in large power loss of the audio power amplifier.

Therefore, how to not only ensure the output power of the audio power amplifier, but also minimize the power loss thereof has become a technical problem to be urgently solved.

### SUMMARY

In view of the above, one of technical problems to be solved in embodiments of the present disclosure is to provide a method for boost power supply, a boost power supply circuit and an audio device, thereby not only ensuring output power of an audio power amplifier, but also reducing power loss thereof, and improving efficiency thereof.

In a first aspect, an embodiment of the present disclosure provides a method for boost power supply, comprising: obtaining a boost threshold that changes synchronously with a power supply voltage; obtaining a signal value of an audio signal in an audio power amplifier, and comparing the signal value with the boost threshold to obtain a check flag signal; generating a corresponding boost control signal based on the check flag signal; obtaining a boosted power supply voltage based on the boost control signal, and powering a power output stage circuit of the audio power amplifier using the boosted power supply voltage.

In a second aspect, an embodiment of the present disclosure provides a boost power supply circuit, comprising: a voltage generation module configured to obtain a boost threshold that changes synchronously with a power supply voltage; a power detection module configured to obtain a signal value of an audio signal in an audio power amplifier, and compare the signal value with the boost threshold to obtain a check flag signal; a boost control module configured to generate a corresponding boost control signal based on the check flag signal; and a self-adaptive voltage boosting circuit configured to obtain a boosted power supply voltage based on the boost control signal, and to power the audio power amplifier using the boosted power supply voltage.

In a third aspect, an embodiment of the present disclosure provides an audio device, comprising the boost power supply circuit according to the second aspect and an audio power amplifier connected to the boost power supply circuit, wherein the boost power supply circuit is configured to power the power output stage circuit of the audio power amplifier using the boosted power supply voltage.

In an embodiment of the present disclosure, a boost threshold that changes synchronously with a power supply voltage is obtained from, and a signal value of an audio signal in an audio power amplifier is compared with the boost threshold to obtain a check flag signal. A corresponding boost control signal is generated based on the check flag signal, and a boosted power supply voltage is obtained based on the boost control signal to power a power output stage circuit of the audio power amplifier. Therefore, embodiments of the present disclosure not only can ensure the output power of the audio power amplifier, but also can reduce the power loss thereof, thereby improving the efficiency of the audio power amplifier.

### BRIEF DESCRIPTION OF DRAWINGS

Some specific embodiments among embodiments of the present disclosure will be detailed below with reference to the drawings in an exemplary manner, instead of a limiting manner. Identical reference numerals in the drawings represent identical or similar components or parts. Those skilled in the art should understand that these drawings may not be drawn to scale. In the drawings:
FIG. 1 is a schematic diagram of a boost power supply circuit;
FIG. 2 is a schematic diagram of another boost power supply circuit;
FIG. 3 is a schematic diagram of still another boost power supply circuit;
FIG. 4 is a schematic boosted voltage waveform diagram of a service voltage;
FIG. 5 is a schematic boosted voltage waveform diagram of another service voltage;
FIG. 6 is a schematic diagram of a boost power supply circuit according to an embodiment of the present disclosure;
FIG. 7 is a flowchart of a method for boost power supply according to an embodiment of the present disclosure;
FIG. 8 is a schematic boosted voltage waveform diagram of still another service voltage;
FIG. 9 is a flowchart of step S2 in a method for boost power supply according to an embodiment of the present disclosure;
FIG. 10 is a schematic circuit diagram of an implementation of a voltage generation module in a boost power supply circuit according to an embodiment of the present disclosure;
FIG. 11 is a schematic circuit diagram of another implementation of a voltage generation module in a boost power supply circuit according to an embodiment of the present disclosure;
FIG. 12 is a schematic circuit diagram of an implementation of a power detection circuit of a boost power supply circuit according to an embodiment of the present disclosure; and
FIG. 13 is a curve diagram of output power versus efficiency for a voltage of a boost power supply circuit according to an embodiment of the present disclosure.

### DETAILED DESCRIPTION

To enable those skilled in the art to better understand technical solutions of embodiments of the present disclosure, the technical solutions of the embodiments of the present disclosure will be clearly described in detail below with reference to drawings in the embodiments of the present disclosure. Apparently, the described embodiments are merely some, instead of all, of the embodiments of the present disclosure. All other embodiments obtained by those of ordinary skills in the art based on some embodiments among the embodiments of the present disclosure shall be encompassed within the scope of protection of the embodiments of the present disclosure.

In the detailed description below, the figures that are referred to form a part of the detailed description thereof, and illustrate example embodiments. In addition, it should be understood that other embodiments may be utilized, and structural and/or logical changes may be made without departing from the scope of the claimed subject matters. It should be further noted that directions and references (e.g., upper, lower, top, bottom, etc.) may be used merely to facilitate description of features in the figures. Therefore, the detailed description below is not to be construed in a limiting sense, and the scope of the claimed subject matter is defined only by the appended claims and equivalents thereof.

In the description below, numerous details are set forth. However, it will be apparent to those skilled in the art that the embodiments herein may be practiced without these particular details. In some instances, well-known method and apparatus are shown in the form of block diagrams, rather than in detail, in order to avoid obscuring the embodiments herein. Reference throughout this specification to "an embodiment" or "one embodiment" or "some embodiments" means that a particular feature, structure, function, or property described in conjunction with the embodiment is included in at least one embodiment herein. Therefore, the appearances of the phrases "in an embodiment" or "in one embodiment" or "in some embodiments" in various places throughout this specification do not necessarily refer to a same embodiment. Further, in one or more embodiments, particular features, structures, functions or properties may be combined in any suitable manner. For example, a first embodiment may be combined with a second embodiment in any case where particular features, structures, functions or properties associated with the two embodiments are not mutually exclusive.

As used in the description and the appended claims, the singular forms "a," "an" and "the" are intended to include plural forms as well, unless the context explicitly indicates otherwise. It should be further understood that the term "and/or" as used herein refers to and includes any and all possible combinations of one or more of the associated recited items.

The terms "coupling" and "connection" along with derivatives thereof may be used herein to describe a functional or structural relationship among components. It should be understood that these terms are not intended as synonyms of each other. On the contrary, in a particular embodiment, the "connection" may be used to indicate that two or more than two elements come in direct physical, optical or electrical contact with each other. The "coupling" may be used to indicate that two or more than two elements come in physical or electrical contact with each other directly or indirectly (with other intervening elements between them), and/or that two or more than two elements cooperate or interact with each other (e.g., as in a causal relationship).

As used herein, the terms "above," "below," "between" and "on" refer to relative positions of one component or material with respect to other components or materials, wherein such physical relationships are noteworthy. For example, in the context of the materials, one material or materials arranged above or below another material may be in direct contact, or may have one or more intervening materials. Further, a material arranged between two materials or materials may be in direct contact with both layers, or may have one or more intervening layers. In contrast, a first material or material "on" a second material or material comes in direct contact with the second material/material. A similar distinction is required in the context of component assembly.

As used throughout the description and in the claims, a list of items connected by the term "at least one of" or "one or more of" may mean any combination of the recited items. For example, the phrase "at least one of A, B or C" may mean A; B; C; A and B; A and C; B and C; or A, B and C.

The term "circuit" or "module" may refer to one or more passive and/or active components arranged to cooperate with each other in providing desired functions. The term "signal" may refer to at least one of a current signal, a voltage signal or a magnetic signal. The terms "substantial," "proximate," "approximate," "approximately" and "about" generally mean within +/-10% of a target value.

The nouns used in the present disclosure are construed as follows:
VDD: Power supply voltage;
VDDmin: Minimum power supply voltage; VDDmax: Maximum power supply voltage;
PVDD: Service voltage;
VTH: Boost threshold; VTH_HYS: Voltage boosting hysteresis threshold;
VOP1, VON1: Differential output signals;
PO: Check flag signal (power check flag signal);
IN+, IN-: Input signals;
y2: Boosted voltage waveform of service voltage;
A: Peak value of boosted voltage waveform;
Tsin: Period of boosted voltage waveform;
a: Lead of boosted voltage waveform;
Trise: Time required for voltage boosting of charge pump;
HR: Headroom between boosted voltage waveform and service voltage;
b: Preset hysteresis amount of boost threshold;
COMP1: First comparison unit;
COMP2: Second comparison unit;
COMP3: Third comparison unit;
R1: First resistor;
R2: Second resistor;
R3: Third resistor;
R4: Fourth resistor;
R5: Fifth resistor;
T1: First triode;
T2: Second triode;
T3: Third triode;
Pomax_VDDmin: Maximum available output power at minimum power supply voltage;
Pomax_VDDmax: Maximum available output power at maximum power supply voltage.

Magnitude of the service voltage may affect efficiency of the audio power amplifier. For an input signal of a certain magnitude, a too large service voltage may cause power loss. Therefore, depending on the magnitude of the input signal, different service voltages may be provided to effectively reduce the power loss.

In order to reduce static power loss in case of a small or no signal input, the audio power amplifier is usually powered by a lower service voltage. As the signal increases, the lower service voltage is boosted to a required service voltage through a boost power supply circuit to continue power supply, to satisfy the output signal power requirements.

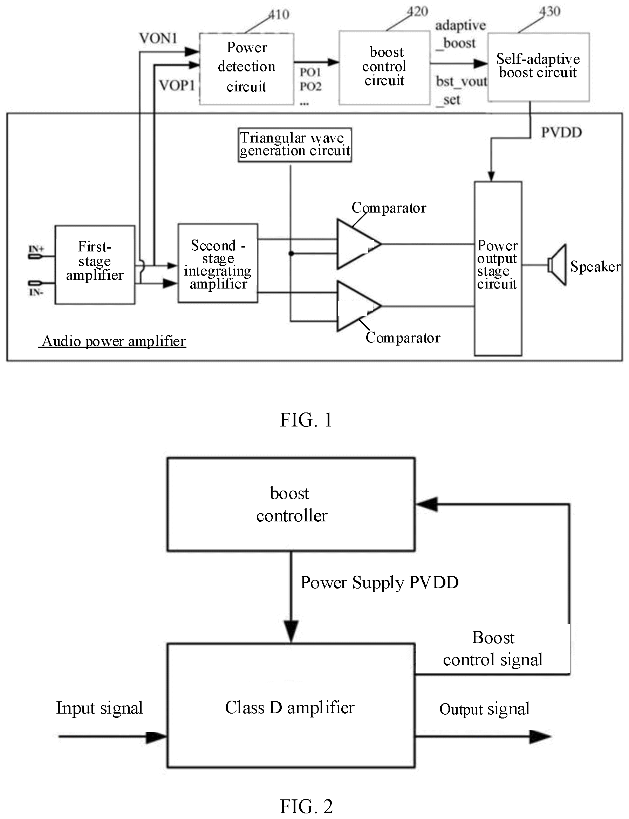

Referring to FIG. 1, a boost power supply circuit comprises: generating a power detection flag signal based on a magnitude of power of an audio input signal; determining whether boosting is required based on the power detection flag signal; generating a boost control signal if voltage boosting is required, and setting a boost threshold setting signal based on the magnitude of the power detection flag signal; switching on a voltage boosting mode based on the boost control signal, outputting a boosted voltage to power a power output stage circuit, and controlling a voltage boosting value based on the boost threshold setting signal.

In addition, referring to FIG. 2, a boost control circuit of another power supply monitors an output signal of an integrator, sets a boost threshold comparison voltage, determines a mode of controlling the power supply, and generates a boost control signal to control a power supply voltage to match an outputted acoustical signal as much as possible.

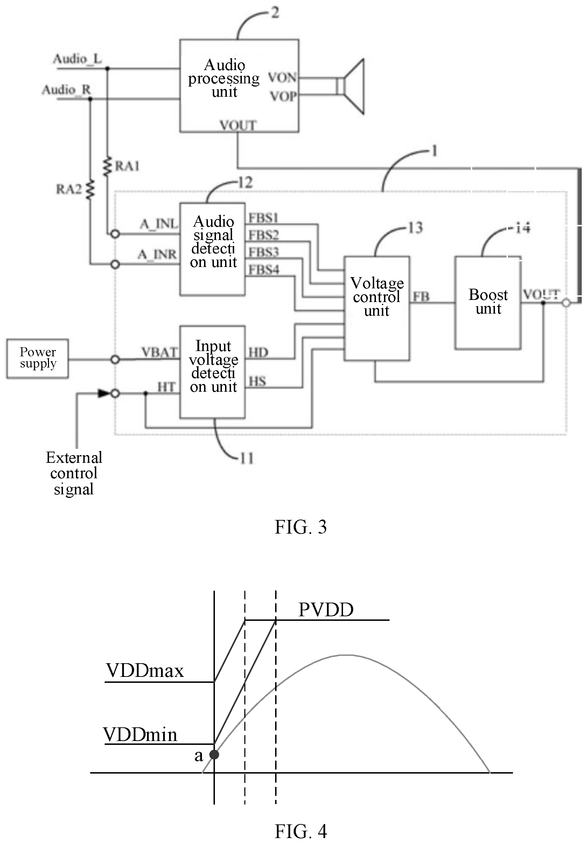

In addition, referring to FIG. 3, still another self-adaptive audio boost circuit comprises: detecting and determining a voltage level of a power supply, and correspondingly generating a level signal of a power supply voltage; detecting a voltage amplitude of an audio input signal, and generating an audio amplitude level signal based on a voltage amplitude of an audio signal; selecting a corresponding voltage level based on the level signal of the power supply voltage, and selecting a corresponding boost control signal of the voltage level in the selected voltage level based on the audio amplitude level signal; and boosting the voltage based on the boost control signal.

As mentioned in the above solutions, in order to satisfy power requirements of an output signal, a boost power supply circuit is usually used. When an input signal is a small signal, a sufficient driving capability can be provided through a lower service voltage; and as the input signal increases, the lower service voltage is boosted through a boost power supply circuit to a required voltage to continue power supply. In order to match the service voltage with the input signal as much as possible without causing signal distortion, multi-level service voltages may be set based on a magnitude of the input signal.

However, since a power supply voltage provided by a battery for power supply is directly associated with battery power, and as the battery power decreases, the outputted power supply voltage also gradually decreases. When the power supply voltage serves as a service voltage of an audio power amplifier, if the service voltage decreases, corresponding load capacity also decreases accordingly. Therefore, in order to allow the battery to work normally in all battery power ranges, the corresponding load capacity can satisfy the output power requirements of the audio power amplifier when the battery outputs a lowest power supply voltage.

Referring to FIG. 4, a range of the power supply voltage outputted from the battery is between a minimum power supply voltage and a maximum power supply voltage, wherein the minimum power supply voltage is VDDmin, and the maximum power supply voltage is VDDmax. Usually, the boost threshold of the boost power supply circuit is designed based on the load capacity corresponding to the minimum power supply voltage outputted from the battery. In FIG. 4, the boost threshold is an ordinate of point a, and is relatively low.

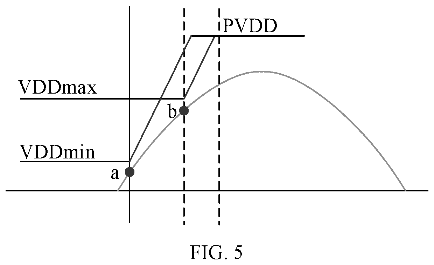

Referring to FIG. 5, in an embodiment of the present disclosure, the boost threshold is designed to change synchronously with the power supply voltage, with the maximum power supply voltage higher than the minimum power supply voltage. If the power supply voltage is boosted, it can provide driving capability for a larger input signal, and the boost threshold changes from point a to point b. The boost threshold changes synchronously with the power supply voltage, so that in an embodiment of the present disclosure, a boost threshold corresponding to the power supply voltage is obtained from under different battery powers, thereby reducing the power loss of the audio power amplifier, and improving the efficiency of the audio power amplifier.

Specific implementations of the embodiments of the present disclosure are further introduced below with reference to the drawings in the embodiments of the present disclosure.

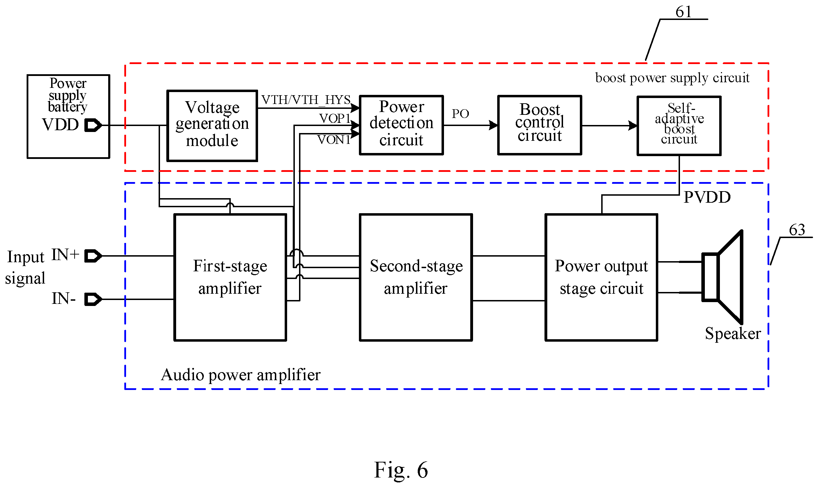

An embodiment of the present disclosure provides a method for boost power supply, applied to a boost power supply circuit, Referring to FIG. 6, the boost power supply circuit 61 is connected to a power supply battery 62 to obtain a power supply voltage provided by the battery 62. The circuit 61 for boost power supply is configured to power an audio power amplifier 63.

Specifically, the audio power amplifier 63 comprises a first-stage amplifier, a second stage amplifier and a power output stage circuit. An input signal is sent to the first-stage amplifier, amplified by the first-stage amplifier, then sent to the second stage amplifier, then sent to the power output stage circuit, and finally sent to a speaker.

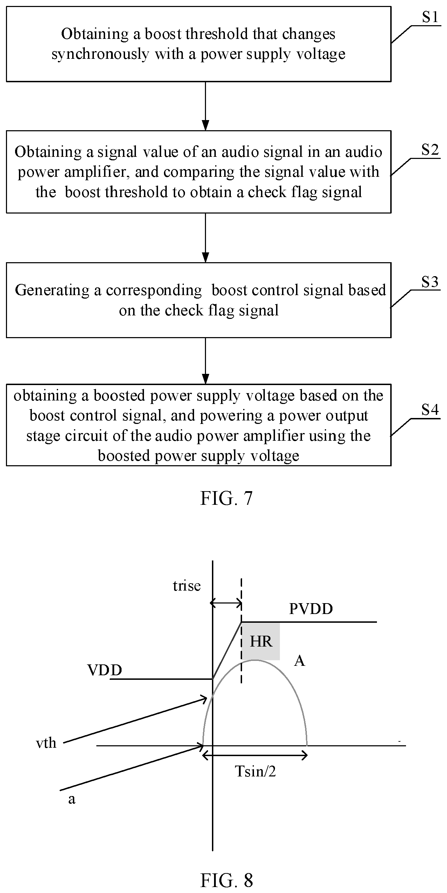

Referring to FIG. 7, the method comprises:
Step S1: obtaining a boost threshold that changes synchronously with a power supply voltage.

Specifically, the boost threshold is generated by a voltage generation module, and sent to a power detection circuit.

In some specific implementations of an embodiment of the present disclosure, the step S1 comprises:
Step S11: obtaining the boost threshold that changes synchronously with the power supply voltage based on a preset model; or
Step S12: obtaining the boost threshold that changes synchronously with the power supply voltage based on a preset mapping between the power supply voltage and the boost threshold.

In an embodiment of the present disclosure, the boost threshold that changes synchronously with the power supply voltage is obtained based on the preset model or the mapping, thereby reducing the power loss of the audio power amplifier, and improving the efficiency of the audio power amplifier.

Further, in an embodiment of the present disclosure, the mapping between the power supply voltage and the boost threshold may also be obtained based on the preset model, thereby obtaining the boost threshold that changes synchronously with the power supply voltage based on the mapping between the power supply voltage and the boost threshold.

In some specific implementations of an embodiment of the present disclosure, the preset model is:
y2(0)=Y(VDD), wherein y2(0) is the boost threshold, Y() is a function, and VDD is the power supply voltage.

Specifically, the preset model is established based on a physical model of a circuit and different application scenarios. In an embodiment of the present disclosure, boost thresholds may be more accurately set for different physical models of a circuit and different application scenarios based on different preset models, thereby further improving the efficiency of the audio power amplifier.

In some specific implementations of an embodiment of the present disclosure, the preset model is: y2(0)=K*VDD, wherein K is a positive number greater than 0; or
$y 2 \left(0\right) = \left\{\begin{matrix}A 1 , 0 < VDD < a 1 ; \\ A 2 , a 1 < VDD < a 2 ; \\ … … \\ An , an - 1 < VDD < an\end{matrix}\right. ;$
wherein A1, A2, ..., and An represent different functions, and a1, a2, ... represent segmented interval values of the power supply voltage VDD.

In an embodiment of the present disclosure, the preset model is implemented based on a linear function or a piecewise function, to satisfy the requirements for various application scenarios and physical models of a circuit, and more accurately set the boost threshold, thereby further improving the efficiency of the audio power amplifier.

The embodiments of the present disclosure are further introduced below in a specific implementation scenario.

Referring to FIG. 8, the boosted voltage waveform of the service voltage is as shown as y2, wherein A is a peak value of a boosted voltage waveform, Tsin is a period of the boosted voltage waveform, representing a magnitude of a signal frequency (1/Tsin), and a is lead of the boosted voltage waveform. A threshold of the service voltage at a voltage boosting moment, that is, the boost threshold, can be obtained based on an intersection of the waveform and y-axis.

Trise is time required for voltage boosting of a charge pump (abbreviated as voltage boosting time). In the figure, HR is headroom, and may be represented as a product of a current generated from the service voltage across a load and a total onresistance (Rdson) of parasitic power loss of an output driver transistor.

Mathematically, for given voltage boosting time, signal frequency 1/Tsin and headroom between the boosted voltage waveform and the service voltage, the power supply voltage is known, and the threshold y2(0), i.e., the boost threshold, that prevents the boosted voltage waveform of the service voltage from being truncated in a voltage boosting process of the service voltage can be calculated.

Specifically, in an embodiment of the present disclosure, different boost thresholds may be set based on different parameters (including the voltage boosting time, the signal frequency 1/Tsin, the headroom between the boosted voltage waveform and the service voltage, the power supply voltage, or addition of other parameters as required).

In a typical application of a voltage doubler charge pump circuit, the preset model of the boost threshold is:
$y 2 \left(0\right) = PVDD * sin \left(a/Tsin*2π\right) = 2 * VDD * sin \left(a/Tsin*2π\right) ,$ wherein a relationship among the head a of the boosted voltage waveform, the period Tsin of the boosted voltage waveform, the headroom between the boosted voltage waveform and the service voltage, the service voltage, and the power supply voltage is consistent with the voltage doubler charge pump circuit.

In an embodiment of the present disclosure, boost thresholds corresponding to different power supply voltages are obtained through model calculation, and then the boost threshold that changes synchronously with the power supply voltage is generated via the voltage generation circuit, thereby boosting the voltage before the signal reaches a maximum available output power of the power supply voltage under different power supply voltages, and ensuring non-occurrence of signal distortion in a particular voltage boosting process, with neither excessive efficiency loss nor signal truncation.

In an embodiment of the present disclosure, the employed preset model can satisfy the typical application of the voltage doubler charge pump circuit, and can be implemented using a simpler circuit design.

Step S2: obtaining a signal value of an audio signal in an audio power amplifier, and comparing the signal value with the boost threshold to obtain a check flag signal.

In an embodiment of the present disclosure, the power detection circuit receives the boost threshold generated by the voltage generation circuit, and compares the resulting signal value of the audio signal in the audio power amplifier with the boost threshold, to generate the check flag signal.

Specifically, the check flag signal may be a current check flag signal, a voltage check flag signal, a power check flag signal, or any other flag signal that can represent a comparison result between the signal value and the boost threshold.

In some other specific implementations of an embodiment of the present disclosure, the signal value of the audio signal is obtained from one of a first-stage amplifier, a second stage amplifier and a power output stage circuit in the audio power amplifier.

In an embodiment of the present disclosure, the signal value of the audio signal may be obtained through one of the first-stage amplifier, the second stage amplifier and the power output stage circuit, the implementation of which is more flexible in an embodiment of the present disclosure.

In still some other specific implementations of an embodiment of the present disclosure, the power detection circuit further obtains a voltage boosting hysteresis threshold corresponding to the boost threshold, wherein the voltage boosting hysteresis threshold is a preset hysteresis amount b of the boost threshold. Those skilled in the art can set the preset amount b as required.

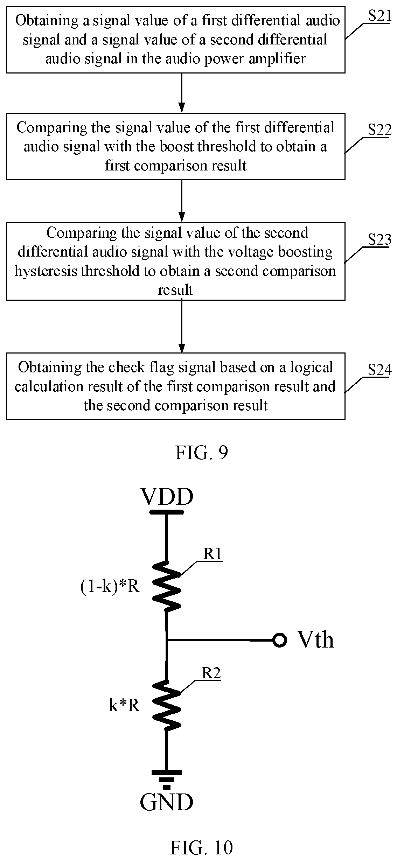

Referring to FIG. 9, the step S2 comprises:
Step S21: obtaining a signal value of a first differential audio signal and a signal value of a second differential audio signal in the audio power amplifier.
Step S22: comparing the signal value of the first differential audio signal with the boost threshold to obtain a first comparison result.
Step S23: comparing the signal value of the second differential audio signal with the voltage boosting hysteresis threshold to obtain a second comparison result.
Step S24: obtaining the check flag signal based on a logical calculation result of the first comparison result and the second comparison result.

In an embodiment of the present disclosure, the signal value of the first differential audio signal and the signal value of the second differential audio signal are compared with the boost threshold and the voltage boosting hysteresis threshold respectively, to avoid the influence of an audio signal noise on the comparison result, so that the comparison result between the signal value of the audio signal and the boost threshold is more accurate.

Step S3: generating a corresponding boost control signal based on the check flag signal.

In an embodiment of the present disclosure, a boost control circuit receives the check flag signal, and generates the corresponding boost control signal based on the check flag signal.

Step S4: obtaining a boosted power supply voltage based on the boost control signal, and powering a power output stage circuit of the audio power amplifier using the boosted power supply voltage.

In an embodiment of the present disclosure, a self-adaptive voltage boosting circuit receives the boost control signal, and obtains the boosted power supply voltage based on the boost control signal. The boosted power supply voltage is used to power the power output stage circuit of the audio power amplifier.

Therefore, in an embodiment of the present disclosure, the boost threshold changes synchronously with the power supply voltage, thereby not only ensuring the output power of the audio power amplifier, but also reducing the power loss thereof, and improving the efficiency thereof.

Corresponding to the above method, an embodiment of the present disclosure further provides a boost power supply circuit. Referring to FIG. 6, the circuit comprises:
a voltage generation module configured to obtain a boost threshold that changes synchronously with a power supply voltage;
a power detection module configured to obtain a signal value of an audio signal in an audio power amplifier, and compare the signal value with the boost threshold to obtain a check flag signal;
a boost control module configured to generate a corresponding boost control signal based on the check flag signal; and
a self-adaptive boost circuit configured to obtain a boosted power supply voltage based on the boost control signal, and to power the audio power amplifier using the boosted power supply voltage.

In an embodiment of the present disclosure, the boost threshold changes synchronously with the power supply voltage, thereby not only ensuring the output power of the audio power amplifier, but also reducing the power loss thereof, and improving the efficiency thereof.

In some specific implementations of an embodiment of the present disclosure, the voltage generation module 101 comprises:
a model-based calculation unit configured to obtain the boost threshold that changes synchronously with the power supply voltage based on a preset model; or
a lookup-table-based retrieval unit configured to obtain the boost threshold that changes synchronously with the power supply voltage based on a preset mapping between the power supply voltage and the boost threshold.

In an embodiment of the present disclosure, the boost threshold that changes synchronously with the power supply voltage is obtained based on the preset model or the mapping, thereby reducing the power loss of the audio power amplifier, and improving the efficiency of the audio power amplifier.

Further, in an embodiment of the present disclosure, the mapping between the power supply voltage and the boost threshold may also be obtained based on the preset model, thereby obtaining the boost threshold that changes synchronously with the power supply voltage based on the mapping between the power supply voltage and the boost threshold.

In some specific implementations of an embodiment of the present disclosure, the preset model is:
$y 2 \left(0\right) = Y \left(VDD\right) ,$ wherein y2(0) is the boost threshold, Y() is a function, and VDD is the power supply voltage.

Specifically, the preset model is established based on a physical model of a circuit and different application scenarios. In an embodiment of the present disclosure, boost thresholds may be more accurately set for different physical models of a circuit and different application scenarios based on different preset models, thereby further improving the efficiency of the audio power amplifier.

In some specific implementations of an embodiment of the present disclosure, the preset model is: y2(0)=K*VDD, wherein K is a positive number greater than 0; or
$y 2 \left(0\right) = \left\{\begin{matrix}A 1 , 0 < VDD < a 1 ; \\ A 2 , a 1 < VDD < a 2 ; \\ … … \\ An , an - 1 < VDD < an\end{matrix}\right. ,$
wherein A1, A2, ..., and An represent different functions, and a1, a2, ... represent segmented interval values of the power supply voltage VDD.

In an embodiment of the present disclosure, the preset model is implemented based on a linear function or a piecewise function, to satisfy the requirements for various application scenarios and a physical model of a circuit, and more accurately set the boost threshold, thereby further improving the efficiency of the audio power amplifier.

The embodiments of the present disclosure are further introduced below in a specific implementation scenario.

Referring to FIG. 8, the boosted voltage waveform of the service voltage is as shown as y2, wherein A is a peak value of a boosted voltage waveform, Tsin is a period of the boosted voltage waveform, representing a magnitude of a signal frequency (1/Tsin), and a is lead of the boosted voltage waveform. A threshold of the service voltage at a voltage boosting moment, that is, the boost threshold, can be obtained based on an intersection of the waveform and y-axis.

Trise is time required for voltage boosting of a charge pump (abbreviated as voltage boosting time). In the figure, HR is headroom, and may be represented as a product of a current generated from the service voltage across a load and a total onresistance (Rdson) of parasitic power loss of the output driver transistor.

Mathematically, for given voltage boosting time, signal frequency 1/Tsin and headroom between the boosted voltage waveform and the service voltage, the power supply voltage is known, and the threshold y2(0), i.e., the boost threshold, that prevents the boosted voltage waveform of the service voltage from being truncated in a voltage boosting process of the service voltage can be calculated.

Specifically, in an embodiment of the present disclosure, different boost thresholds may be set based on different parameters (including the voltage boosting time, the signal frequency 1/Tsin, the headroom between the boosted voltage waveform and the service voltage, and the power supply voltage).

In the typical application of the voltage doubler charge pump circuit, the preset model of the boost threshold is: y2(0)=PVDD*sin(a/Tsin*2π)=2*VDD*sin(a/Tsin*2π), wherein a relationship among the head a of the boosted voltage waveform, the period Tsin of the boosted voltage waveform, the headroom between the boosted voltage waveform and the service voltage, the service voltage, and the power supply voltage is consistent with the voltage doubler charge pump circuit.

In an embodiment of the present disclosure, boost thresholds corresponding to different power supply voltages are obtained through model calculation, and then the boost threshold that changes synchronously with the power supply voltage is generated via the voltage generation circuit, thereby boosting the voltage before the signal reaches a maximum available output power of the power supply voltage under different power supply voltages, and ensuring non-occurrence of signal distortion in a particular voltage boosting process, with neither excessive efficiency loss nor signal truncation.

In an embodiment of the present disclosure, the employed preset model can satisfy the typical application of the voltage doubler charge pump circuit, and can be implemented using a simpler circuit design.

Based on the above formula, the voltage generation module can be implemented via a voltage divider circuit.

Specifically, referring to FIG. 10, the voltage generation module comprises: a first resistor R1 and a second resistor R2 connected in series; wherein a first end of the first resistor R1 is connected to the power supply voltage, a second end of the first resistor R1 is connected to a first end and a boost threshold output end of the second resistor R2 respectively, and a second end of the second resistor R2 is grounded.

A resistance ratio of the first resistor R1 to the second resistor R2 is (1-k)/k.

A circuit used in the voltage generation module in an embodiment of the present disclosure is simple, and can be easily implemented.

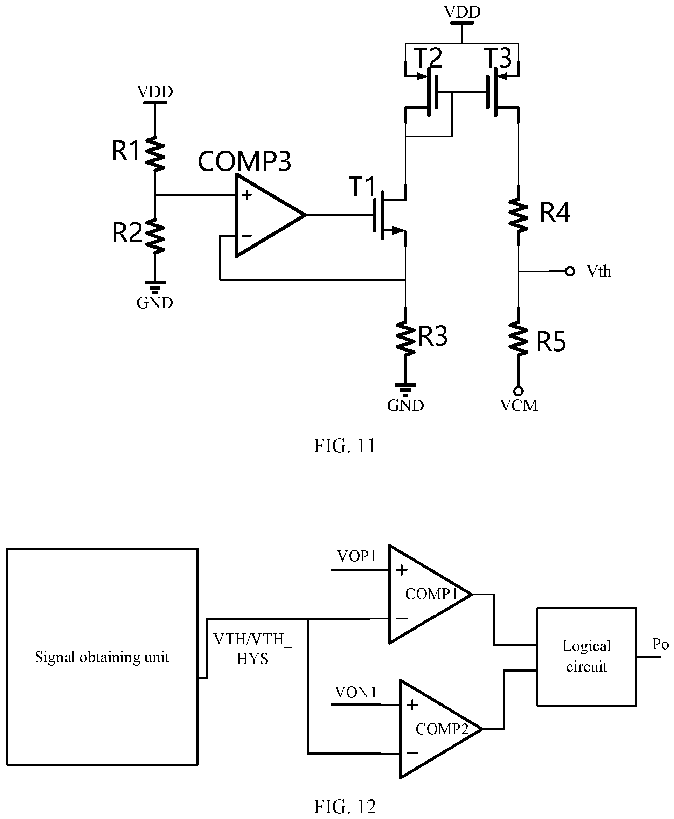

In order to further improve the anti-interference ability of the voltage generation module, referring to FIG. 11, the voltage generation module further comprises: a third comparison unit and an amplification circuit connected to the third comparison unit. The second end of the first resistor is connected to the first end of the second resistor and a positive input end of the third comparison unit respectively, a negative input end of the third comparison unit is grounded, and an output end of the third comparison unit is connected to the amplification circuit.

Specifically, the third comparison unit is a third comparator, and the amplification circuit comprises a first triode, a second triode, a third triode, a third resistor, a fourth resistor, and a fifth resistor. The output end of the third comparator is connected to a base electrode of the first triode, an emitter electrode of the first triode is grounded through the third resistor, and a collector electrode of the first triode is connected to a collector electrode of the second triode, a base electrode of the second triode and a base electrode of the third triode respectively, the base electrode of the second triode and the base electrode of the third triode are connected to each other, an emitter electrode of the second triode and an emitter electrode of the third triode are connected to each other and are connected to the power supply voltage, and a collector electrode of the third triode is connected to a common mode voltage sequentially through the fourth resistor and the fifth resistor, with the boost threshold output end between the fourth resistor and the fifth resistor.

In still some other specific implementations of an embodiment of the present disclosure, the voltage generation module further obtains a voltage boosting hysteresis threshold corresponding to the boost threshold, wherein the voltage boosting hysteresis threshold is a preset hysteresis amount b of the boost threshold.

Referring to FIG. 12, the power detection module comprises:
a signal obtaining unit configured to obtain a signal value of a first differential audio signal and a signal value of a second differential audio signal in the audio power amplifier;
a first comparison unit configured to compare the signal value of the first differential audio signal with the boost threshold to obtain a first comparison result;
a second comparison unit configured to compare the signal value of the second differential audio signal with the voltage boosting hysteresis threshold to obtain a second comparison result; and
a logical circuit configured to obtain the check flag signal based on a logical calculation result of the first comparison result and the second comparison result.

In yet some other specific implementations of an embodiment of the present disclosure, the signal value of the audio signal is obtained from one of a first-stage amplifier, a second stage amplifier and a power output stage circuit in the audio power amplifier.

In an embodiment of the present disclosure, the signal value of the audio signal may be obtained through one of the first-stage amplifier, the second stage amplifier and the power output stage circuit, the implementation of which is more flexible in an embodiment of the present disclosure.

In an embodiment of the present disclosure, the signal value of the first differential audio signal and the signal value of the second differential audio signal are compared with the boost threshold and the voltage boosting hysteresis threshold respectively, to avoid the influence of an audio signal noise on the comparison result, so that the comparison result between the signal value of the audio signal and the boost threshold is more accurate.

Specifically, the first comparison unit COMP1 and the second comparison unit COMP1 are each a comparator, wherein the signal value of the first differential audio signal is inputted into a positive input end of the first comparison unit, and the boost threshold is inputted into a negative input end of the first comparison unit; and the signal value of the second differential audio signal is inputted into a positive input end of the second comparison unit, and the voltage boosting hysteresis threshold is inputted into a negative input end of the second comparison unit. When the audio signal is detected to be greater than the corresponding threshold, the comparator flips over, a logical calculation unit 1024 outputs the corresponding boost control signal, and the corresponding check flag signal Po is associated with the power supply voltage.

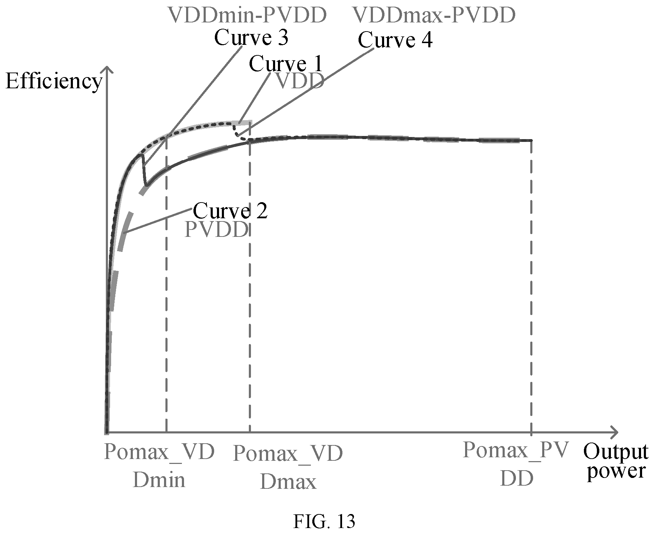

Referring to FIG. 13, curve 1 is an efficiency curve of a maximum available output power of the power supply voltage, and curve 2 is an efficiency curve of a maximum available output power of the service voltage. For an input signal of a certain magnitude, a too large service voltage may cause power loss. Under a given output power, the higher the service voltage is, the greater the power loss is, but a low service voltage fails to output a large output power. Therefore, the power supply voltage is selected at a lower output power for power supply to achieve a higher efficiency, while the service voltage is selected at a higher power to satisfy the output power requirements.

Generally, in order to ensure enough output power across the entire power supply range (both minimum and maximum power supply voltages) without truncation distortion, voltage boosting is required prior to a maximum boost control signal at a minimum power supply voltage, thereby resulting in a low boost threshold, as shown by curve 3 in FIG. 13. However, in the present disclosure, the boost threshold changes synchronously with the power supply voltage. As the power supply voltage is boosted from the minimum power supply voltage to the maximum power supply voltage, the boost threshold is boosted synchronously, with the efficiency curve as shown by curve 4 in FIG. 13, thereby achieving a higher efficiency across the entire power supply range.

So far, particular embodiments of this subject matter have been described. Other embodiments are encompassed within the scope of the appended claims. In some cases, actions disclosed in the claims may be executed in different orders and can still achieve desired results. In addition, the processes depicted in the figures are not necessarily required to achieve the desired results in the shown particular order or sequential order. In some embodiments, multitasking and parallel processing may be advantageous.

In the 1990s, an improvement of a technology can be obviously distinguished between a hardware improvement (e.g., an improvement on a circuit structure of a diode, a transistor, a switch, or the like) or a software improvement (e.g., an improvement on a process flow). However, with the development of the technology, at present, improvements of many method flows can be regarded as direct improvements on a hardware circuit structure. Almost all designers obtain a corresponding hardware circuit structure by programming the improved method flows into a hardware circuit. Therefore, it cannot be said that an improvement on a method flow cannot be implemented with hardware entity modules. For example, a programmable logic device (PLD) (e.g., a Field Programmable Gate Array (FPGA)) is such an integrated circuit that its logical functions are user-determined by programming a device. A designer "integrates" a digital system onto a PLD by programming by himself without requiring a chip manufacturer to design and manufacture a dedicated integrated circuit chip. Further, at present, instead of manually making integrated circuit chips, this kind of programming is mostly implemented by using "logic compiler" software, which is similar to a software compiler used in program development and compilation. The original code prior to the compilation must also be compiled in a particular programming language, which is referred to as a hardware description language (HDL) including not only one kind, but many kinds of HDL, e.g., ABEL (Advanced Boolean Expression Language), AHDL (Altera Hardware Description Language), Confluence, CUPL (Cornell University Programming Language), HDCal, JHDL (Java Hardware Description Language), Lava, Lola, MyHDL, PALASM, and RHDL (Ruby Hardware Description Language). At present, VHDL (Very-HighSpeed Integrated Circuit Hardware Description Language) and Verilog are most commonly used. Those skilled in the art should further clearly know that it will be very easy to obtain a hardware circuit that implements the logical method flow only by slightly logically programming the method flow with the above hardware description languages and programming the method flow into an integrated circuit.

The controller may be implemented in any suitable manner. For example, the controller may take the form of a microprocessor or a processor and a computer-readable medium storing computer-readable program code (such as software or firmware) executable by the (micro)processor, a logic gate, a switch, an application specific integrated circuit (ASIC), a programmable logic controller, and an embedded microcontroller. Examples of the controller include, but are not limited to, the following microcontrollers: ARC 625D, Atmel AT91SAM, Microchip PIC18F26K20, and Silicone Labs C8051F320. A memory controller may also be implemented as a part of the memory control logic. Those skilled in the art also know that the controller not only can be implemented in a manner of purely computer-readable program code, but also can achieve same functions completely in the form of, e.g., a logic gate, a switch, an application specific integrated circuit, a programmable logic controller and an embedded microcontroller by logically programming the steps of the method. Therefore, such a controller may be regarded as a hardware component, and an apparatus included therein and configured to implement various functions may also be regarded as a structure within the hardware component. Or even, it may be regarded that the apparatus configured to implement various functions may be a software module for implementing the method, or may be a structure within the hardware component.

The system, apparatus, modules or units illustrated in the above embodiments may be specifically implemented by a computer chip or entity, or by a product having a function. A typical implementing device is a computer. Specifically, the computer may be, e.g., a personal computer, a laptop computer, a cellular phone, a camera phone, a smart phone, a personal digital assistant, a medium player, a navigation device, an e-mail device, a game console, a tablet computer, a wearable device, or a combination of any device among these devices.

For ease of description, the above apparatus is described by dividing the apparatus into various units based on functions, and then describing the units respectively. Of course, when the present disclosure is implemented, the functions of the units may be implemented in a same or more software and/or hardware components.

Those skilled in the art should understand that the embodiments of the present disclosure may be provided as a method, a system, or a computer program product. Accordingly, the present disclosure may take the form of an entirely hardware embodiment, an entirely software embodiment, or an embodiment combining software and hardware. Further, the present disclosure may take the form of a computer program product embodied on one or more computer-usable storage mediums (including, but not limited to, a disk memory, a CD-ROM, an optical memory, and the like) having computer-usable program code embodied thereon.

The present disclosure is described with reference to the flow charts and/or block diagrams of the method, device (system), and computer program product according to the embodiments of the present disclosure. It should be understood that each process and/or block in the flow charts and/or block diagrams as well as combinations of processes and/or blocks in the flow charts and/or block diagrams may be implemented by computer program instructions. The computer program instructions may be provided to a processor of a general-purpose computer, a special-purpose computer, an embedded processing machine, or other programmable data processing devices to produce a machine, thereby producing an apparatus for implementing the functions specified in one or more processes in the flow charts and/or one or more blocks in the block diagrams based on the instructions executed by the processor of the computer or other programmable data processing devices.

These computer program instructions may also be stored in a computer-readable memory that can direct a computer or other programmable data processing devices to function in a particular manner, such that the instructions stored in the computer-readable memory produce an article of manufacture including an instruction apparatus which implements the functions specified in one or more processes in the flow charts and/or one or more blocks in the block diagrams.

The computer program instructions may also be loaded onto a computer or other programmable data processing devices, so that a series of operational steps are executed on the computer or other programmable devices, to produce a computer implemented process, such that the instructions executed on the computer or other programmable devices provide steps for implementing the functions specified in one or more processes in the flow charts and/or one or more blocks in the block diagrams.

In a typical configuration, a computing device comprises one or more processors (CPU), an input/output interface, a network interface, and an internal memory.

The internal memory may include forms, such as a volatile memory, a random-access memory (RAM), and/or a nonvolatile internal memory, e.g., a read-only memory (ROM) or a flash RAM, in a computer-readable medium. The internal memory is an example of the computer-readable medium.

The computer-readable medium includes permanent and non-permanent mediums and removable and non-removable mediums, and information storage may be implemented using any method or technology. The information may be a computer-readable instruction, a data structure, a program module or other data. Examples of computer storage mediums include, but are not limited to, a phase-change random-access memory (PRAM), a static random-access memory (SRAM), a dynamic random-access memory (DRAM), a random-access memory (RAM) of an additional type, a read-only memory (ROM), an electrically erasable programmable read-only memory (EEPROM), a flash memory or an additional internal memory technology, a compact disc read-only memory (CD-ROM), a digital versatile disc (DVD) or additional optical storage, a magnetic cassette tape, a magnetic tape or disk storage or other magnetic storage devices, or any other non-transmission medium, which may be configured to store information accessible to a computing device. As defined herein, the computer-readable medium excludes a transitory medium, e.g., a modulated data signal or carrier wave.

It should be further noted that the terms such as "comprising," "including," or any other variation thereof are intended to encompass non-exclusive inclusions, such that a process, a method, an article, or a device that includes a series of elements not only includes those elements, but also includes other elements that are not explicitly recited, or further includes elements that are inherent to such a process, method, article, or device. In the case of no more constraints, an element defined by the wording "comprising a ..." does not preclude the existence of additional identical elements in a process, a method, an article, or a device that includes the element.

Those skilled in the art should understand that the embodiments of the present disclosure may be provided as a method, a system or a computer program product. Accordingly, the present disclosure may take the form of an entirely hardware embodiment, an entirely software embodiment, or an embodiment combining software and hardware. Further, the present disclosure may take the form of a computer program product embodied on one or more computer-usable storage mediums (including, but not limited to, a disk memory, a CD-ROM, an optical memory, and the like) having computer-usable program code embodied thereon.

The present disclosure may be described in a general context of computerexecutable instructions executed by a computer, e.g., program modules. Generally, the program modules include routines, programs, objects, components, data structures, etc. that execute particular tasks or implement particular abstract data types. The present disclosure may also be practiced in a distributed computing environment. In these distributed computing environments, tasks are executed by remote processing devices connected through a communication network. In a distributed computing environment, the program modules may be located in local and remote computer storage mediums including storage devices.

The various embodiments in the present specification are described in a progressive manner, with identities or similarities among the embodiments referring to one another, and each embodiment focuses on introduction of aspects that differentiate it from the other embodiments. In particular, system embodiments are substantially similar to method embodiments, and therefore are relatively simply described. A part of description of the method embodiments may be referred to for relevant details.

The above is merely preferred embodiments of the present disclosure, and is not intended to limit the present disclosure. For those skilled in the art, the present disclosure may have various modifications and alterations. Any modification, equivalent replacement, improvement, and the like made within the spirit and principle of the present disclosure should be encompassed within the scope of the appended claims of the present disclosure.

## Claims

1. A method for boost power supply, comprising:
obtaining a boost threshold that changes synchronously with a power supply voltage;
obtaining a signal value of an audio signal in an audio power amplifier, and comparing the signal value with the boost threshold to obtain a check flag signal;
generating a corresponding boost control signal based on the check flag signal;
obtaining a boosted power supply voltage based on the boost control signal, and powering a power output stage circuit of the audio power amplifier using the boosted power supply voltage.

2. The method according to claim 1, wherein obtaining the boost threshold that changes synchronously with a power supply voltage comprises:
obtaining a voltage boosting hysteresis threshold corresponding to the boost threshold, wherein the voltage boosting hysteresis threshold lags behind the boost threshold by a preset hysteresis amount; and
wherein obtaining the signal value of the audio signal in the audio power amplifier, and comparing the signal value with the boost threshold to obtain the check flag signal comprises:
obtaining a signal value of a first differential audio signal and a signal value of a second differential audio signal in the audio power amplifier;
comparing the signal value of the first differential audio signal with the boost threshold to obtain a first comparison result;
comparing the signal value of the second differential audio signal with the voltage boosting hysteresis threshold to obtain a second comparison result; and
obtaining the check flag signal based on a logical calculation result of the first comparison result and the second comparison result.

3. The method according to claim 1, wherein obtaining the boost threshold comprises:
obtaining the boost threshold that changes synchronously with the power supply voltage based on a preset model; or
obtaining the boost threshold that changes synchronously with the power supply voltage based on a preset mapping between the power supply voltage and the boost threshold.

4. The method according to claim 3, wherein the preset model is established based on a physical model of a circuit and different application scenarios.

5. The method according to claim 4, wherein the preset model is: $y 2 \left(0\right) = Y \left(VDD\right) ,$ wherein y2(0) is the boost threshold, Y() represents a function, and VDD is the power supply voltage.

6. The method according to claim 5, wherein the preset model is: y2(0)=K*VDD, wherein K is a positive number greater than 0; or $y 2 \left(0\right) = \left\{\begin{matrix}A 1 , 0 < VDD < a 1 ; \\ A 2 , a 1 < VDD < a 2 ; \\ … … \\ An , an - 1 < VDD < an\end{matrix}\right. ,$ wherein A1, A2, ..., and An represent different functions, and a1, a2, ... represent segmented interval values of the power supply voltage VDD.

7. The method according to claim 1, wherein the signal value of the audio signal is obtained from one of a first-stage amplifier, a second stage amplifier, and the power output stage circuit of the audio power amplifier.

8. A boost power supply circuit, comprising:
a voltage generation module configured to obtain a boost threshold that changes synchronously with a power supply voltage;
a power detection module configured to obtain a signal value of an audio signal in an audio power amplifier, and compare the signal value with the boost threshold to obtain a check flag signal;
a boost control module configured to generate a corresponding boost control signal based on the check flag signal; and
a self-adaptive boost circuit configured to obtain a boosted power supply voltage based on the boost control signal, and to power the audio power amplifier using the boosted power supply voltage.

9. The circuit according to claim 7, wherein the voltage generation module is further configured to:
obtain a voltage boosting hysteresis threshold corresponding to the boost threshold, wherein the boost hysteresis threshold lags behind the boost threshold by a preset hysteresis amount; and
the power detection module comprises:
a signal obtaining unit configured to obtain a signal value of a first differential audio signal and a signal value of a second differential audio signal in the audio power amplifier;
a first comparison unit configured to compare the signal value of the first differential audio signal with the boost threshold to obtain a first comparison result;
a second comparison unit configured to compare the signal value of the second differential audio signal with the voltage boosting hysteresis threshold to obtain a second comparison result; and
a logical circuit configured to obtain the check flag signal based on a logical calculation result of the first comparison result and the second comparison result.

10. The circuit according to claim 8, wherein the voltage generation module comprises:
a model-based calculation unit configured to obtain the boost threshold that changes synchronously with the power supply voltage based on a preset model; or
a lookup-table-based retrieval unit configured to obtain the boost threshold that changes synchronously with the power supply voltage based on a preset mapping between the power supply voltage and the boost threshold.

11. The circuit according to claim 10, wherein the preset model is established based on a physical model of a circuit and different application scenarios.

12. The circuit according to claim 11, wherein the preset model is:
y2(0)=Y(VDD), wherein y2(0) is the boost threshold, Y() represents a function, and VDD is the power supply voltage.

13. The circuit according to claim 12, wherein the preset model is: y2(0)=K*VDD, wherein K is a positive number greater than 0; or $y 2 \left(0\right) = \left\{\begin{matrix}A 1 , 0 < VDD < a 1 ; \\ A 2 , a 1 < VDD < a 2 ; \\ … … \\ An , an - 1 < VDD < an\end{matrix}\right. ,$ wherein A1, A2, ..., and An represent different functions, and a1, a2, ... represent segmented interval values of the power supply voltage VDD.

14. An audio device, comprising the boost power supply circuit according to any one of claims 8 to 13 and an audio power amplifier connected to the boost power supply circuit, wherein the boost power supply circuit is configured to power a power output stage circuit of the audio power amplifier using the boosted power supply voltage.
